# EUROPÄISCHE PATENTSCHRIFT

(11) **EP 1 456 911 B1**
(45) Veröffentlichungstag und Bekanntmachung des Hinweises auf die Patenterteilung: **11.10.2006**
(21) Anmeldenummer: 02787905.5
(22) Anmeldetag: 04.12.2002
(51) Int. Cl.: H01R 12/24

(54) **AUFBAU- UND VERBINDUNGSTECHNIK IN TEXTILEN STRUKTUREN**
ASSEMBLY AND CONNECTING TECHNIQUE IN TEXTILE STRUCTURES
TECHNIQUE D'ASSEMBLAGE ET DE CONNEXION MISE EN OEUVRE DANS DES STRUCTURES TEXTILES

(30) Priorität: 14.12.2001 DE 10161527
(43) Veröffentlichungstag der Anmeldung: 15.09.2004
(73) Patentinhaber: Infineon Technologies AG, 81669 München (DE); Interactive Wear AG, 82319 Starnberg (DE)
(72) Erfinder: JUNG, Stefan, 81249 München (DE); LAUTERBACH, Christl, 85635 Höhenkirchen-Siegertsbrunn (DE)
(74) Vertreter: Müller-Boré & Partner Patentanwälte
(86) Internationale Anmeldenummer: PCT/EP2002/013745
(87) Internationale Veröffentlichungsnummer: WO 2003/052875

(56) Entgegenhaltungen:
- WO-A-02/095839
- GB-A- 2 148 058
- US-A- 5 089 669
- PATENT ABSTRACTS OF JAPAN vol. 1996, no. 08, 30. August 1996 (1996-08-30) & JP 08 106939 A (FUJI KOBUNSHI KOGYO KK), 23. April 1996 (1996-04-23)

## Beschreibung

Die Erfindung betrifft ein Verfahren zum elektrischen Verbinden eines elektrischen Leiters mit einem elektronischen Bauelement gemäß Anspruch 1 sowie eine Vorrichtung gemäß Anspruch 12.

Die Integration von elektronischen Komponenten in eine textile Umgebung erfordert eine spezielle Aufbau- und Verbindungstechnik (AVT), welche eine zuverlässige elektrische Verbindung konventioneller elektronischer Baugruppen, beispielsweise integrierter Schaltkreise, Platinen oder Module, mit einer textilen Struktur gestattet. Anforderungen an eine derartige Aufbau- und Verbindungstechnik müssen insbesondere auf die bei der Verwendung des textilen Materials in der Bekleidung auftretenden mechanischen, thermischen und chemischen Belastungen, der paßgenauen Plazierung und Verarbeitung auch über Nahtstellen in dem textilen Material hinweg sowie eventuell notwendigen elektrischen Isolierungseigenschaften genügen. Zu berücksichtigen ist ebenfalls, daß die Größe und der Abstand der Kontaktstellen auf typischen elektronischen Bauelementen mit ca. 100 µm im allgemeinen kleiner als die auf der textilen Seite auftretende Periode ist. Großtechnische Fertigungsverfahren sind in dem gesamten Umfeld der "wearable electronics" bislang nicht bekannt.

Eine Vorrichtung nach dem Oberbegriff des Anspruchs 12 ist aus dem Dokument CH 682964 bekannt.

Es ist somit Aufgabe der Erfindung, ein Verfahren zum elektrischen Verbinden einer textilen Struktur mit einem elektronischen Bauelement vorzuschlagen, welches eine mechanisch, chemisch und thermisch belastbare elektrische Verbindung ermöglicht und in einen großtechnischen Fertigungsprozeß eingebunden werden kann. Es ist ferner Aufgabe der Erfindung, eine entsprechende Vorrichtung anzugeben.
Die das Verfahren betreffende Aufgabe wird durch ein Verfahren zum elektrischen Verbinden eines elektrischen Leiters mit einem elektronischen Bauelement gemäß Anspruch 1 gelöst. Die die Vorrichtung betreffende Aufgabe wird durch eine Vorrichtung gemäß Anspruch 12 gelöst. Bevorzugte Ausführungsformen sind Gegenstand der abhängigen Ansprüche.

Erfindungsgemäß umfaßt ein Verfahren zum elektrischen Verbinden eines elektrischen Leiters mit einem elektronischen Bauelement die Schritte:
- Bereitstellen eines textilen Materials, in welchem zumindest ein flexibler, draht- und/oder fadenartiger elektrischer Leiter angeordnet ist;
- Positionieren des elektrischen Leiters des textilen Materials relativ zu einer elektrisch leitfähigen Kontaktstelle eines elektronischen Bauelements; und
- elektrisches Verbinden des Leiters mit der Kontaktstelle.

Der Schritt des Positionierens des elektrischen Leiters, welcher in dem textilen Material angeordnet ist, relativ zu der elektrisch leitfähigen Kontaktstelle umfaßt insbesondere das Annähern und Plazieren des elektrischen Leiters vorzugsweise in Berührung oder unmittelbare Nähe der Kontaktstelle. Bei dem elektronischen Bauelement kann es sich beispielsweise um eine integrierte Schaltung (Chip) oder um eine auf einem Isolator aufgebrachte Leiterbahn, welche mit einem externen elektronischen Bauelement verbunden ist, handeln.

Vorzugsweise ist das textile Material ein Gewebe und der Leiter umfaßt zumindest einen Schuß- und/oder Kettfaden des Gewebes. Unter einem Gewebe wird hierbei ein textiles Flächengebilde aus zwei sich insbesondere rechtwinklig kreuzenden Fadensystemen verstanden, welche - wie üblich - als Kette und Schuß bezeichnet werden. Die Kette liegt in Längsrichtung des Webprozesses während die Schußrichtung quer zur Webrichtung verläuft. Bei dem Leiter kann es sich um Kunstfäden mit darin eingesponnenen leitfähigen feinen Metalldrähten handeln. Alternativ kann der Leiter auch aus einem dünnen Metalldraht, beispielsweise einem feinen Silber- oder Kupferdraht, bestehen, welcher einen Schuß- bzw. Kettfaden des Gewebes bildet. Bevorzugt besteht der Leiter nicht aus einem einzigen Schuß- oder Kettfaden, sondern aus einer Vielzahl im Gewebe insbesondere benachbart angeordneter Schuß- bzw. Kettfäden. Eine elektrische Unterbrechung eines feinen Metalldrahtes in einem der Fäden führt dann nicht zu einer Unterbrechung der elektrischen Leitfähigkeit des Leiters, so daß sich eine redundante Anordnung mit höherer Zuverlässigkeit ergibt. Um eine bessere elektrische Verbindung des Leiters mit der Kontaktstelle zu gewährleisten, kann es von Vorteil sein, Schuß- bzw. Kettfäden, welche an den Leiter im Bereich des Kontaktierungsgebiets angrenzen, vor dem elektrischen Verbinden des Leiters mit der Kontaktstelle zu entfernen.

Vorzugsweise weist der Leiter eine elektrische Isolierung auf und der Schritt des Verbindens des Leiters mit der Kontaktstelle umfaßt das zumindest teilweise chemische und/oder thermische Entfernen der Isolierung. In einer textilen Struktur mit parallel verlaufenden Gruppen von Fäden, die abwechselnd elektrisch leitfähig und isolierend sind, werden die in die leitfähigen Garne eingebetteten feinen Metalldrähte vorzugsweise mit einer Schutzschicht zur elektrischen Isolierung versehen, damit es insbesondere beim Falten oder lateralen Zusammendrücken des Gewebes nicht zu einem direkten elektrischen Kontakt zwischen Fäden verschiedener Leiter - und damit zu elektrischen Kurzschlüssen - kommt. Auch könnten im Fall der Verwendung nicht-isolierter Drähte Kriechströme bzw. Kurzschlüsse auftreten, wenn das Gewebe beispielsweise von Feuchtigkeit durchdrungen wird und sich somit Strompfade auch zwischen weit voneinander entfernten Leiterfäden ausbilden könnten. Dies gilt besonders dann, wenn Gruppen leitfähiger Fäden senkrecht zueinander in der textilen Struktur verlaufen (elektrisch leitfähige Schuß- und Kettfäden) und somit Kreuzungspunkte aufweisen.

Die Schutzschicht zur elektrischen Isolierung der feinen Metalldrähte muß einerseits derart robust sein, daß sie sowohl bei der Herstellung des Fadens (Spinnprozeß etc.) als auch bei dem Herstellungsprozeß des Gewebes (Web-, Näh- und Strickprozeß etc.) nicht beschädigt wird und auch, insbesondere wenn die textile Struktur in einer Konfektion eingesetzt wird, eventuell auftretenden mechanischen, thermischen und chemischen Belastungen standhält. Vor dem elektrischen Verbinden des Leiters mit der Kontaktstelle bzw. während dieses Schritts muß diese elektrische Isolierung entfernt werden, damit ein zuverlässiger elektrischer Kontakt zwischen dem Leiter und der Kontaktstelle hergestellt werden kann. Alternativ kann ein textiles Material bereitgestellt werden, welches einen zunächst nicht-isolierten Leiter aufweist. Nach dem elektrischen Verbinden des elektrisch nicht-isolierten Leiters mit der Kontaktstelle kann in einem nachfolgenden Prozeßschritt durch beispielsweise einen Imprägnierschritt oder durch galvanisches Abscheiden von isolierendem Material (z.B. Polymeren) auf dem metallischen Leiter eine elektrische Isolierung eingebracht werden, welche den Leiter vor unbeabsichtigten elektrischen Kurzschlüssen schützt.

Vorzugsweise umfaßt der Schritt des elektrischen Verbindens des Leiters mit der Kontaktstelle das Aufbringen eines Lotmittels auf zumindest einen Bereich der Kontaktstelle und das mechanische Andrücken des Leiters auf die mit Lotmittel versehene Kontaktstelle. Überraschenderweise wurde festgestellt, daß ein einfaches Erhitzen der mit Lotmittel versehenen Kontaktstelle, an welcher der elektrisch zu verbindende Leiter angeordnet ist, nur bedingt zu befriedigenden elektrischen Verbindungsergebnissen führt. Die elektrische Verbindung kann jedoch dadurch erheblich verbessert werden, daß der Schritt des elektrischen Verbindens des Leiters mit der Kontaktstelle den Schritt des mechanischen Andrückens des Leiters auf die mit Lotmittel versehene Kontaktstelle umfaßt. Besteht der Leiter beispielsweise aus Kunstfasern mit einem eingesponnenen, elektrisch isolierten Metalldraht, so ist die auf das mechanische Andrücken zurückzuführende Verbesserung der elektrischen Verbindungseigenschaften durch einen mechanischen Verdrängungsprozeß der thermisch zersetzten Isolierummantelung zurückzuführen, welcher es ermöglicht, daß das Lotmittel mit einer größeren Oberfläche des Metalldrahts in Berührung treten kann. Im Vergleich zu Verbindungsverfahren, bei welchen in einem "statischen" Zustand lediglich das Lotmittel aufgeschmolzen wird, erzielt ein derartiges "dynamisches" mechanisches Andrückverfahren bessere elektrische Verbindungsergebnisse.

Vorzugsweise erfolgt das Andrücken des Leiters mittels einer Löteinrichtung. Die Löteinrichtung kann beispielsweise die Spitze einer industriellen Lotvorrichtung sein, welche Hitze und eventuell zusätzliches Lotmittel zuführt.

Alternativ kann vorgesehen sein, daß die Kontaktstelle zumindest bereichsweise mit einem Leitkleber beschichtet ist, welcher vorzugsweise chemische Inhaltsstoffe aufweist, die eine eventuelle Isolierummantelung des zumindest einen feinen Metalldrahts des Leiters zerstören. Auch in diesem Fall verbessert der Schritt des mechanischen Andrückens den elektrischen Kontakt zwischen Leiter und Kontaktstelle.

Gemäß einer bevorzugten Ausführungsform der Erfindung umfaßt das Bauelement eine Vielzahl von elektrisch leitfähigen Kontaktstellen, das textile Material eine Vielzahl von elektrischen Leitern und der Schritt des Positionierens das gleichzeitige Anordnen der Leiter an die Kontaktstellen. Dieses für eine industrielle Massenproduktion besonders geeignete Verbindungsverfahren basiert auf einem simultanen elektrischen Verbindungsprozeß einer Vielzahl elektrischer Leiter mit einer Vielzahl entsprechender Kontaktstellen. Die Leiter können beispielsweise jeweils aus zumindest einem Schuß- bzw. Kettfaden eines textilen Gewebes bestehen. Diese vorbestimmte Leiteranordnung kann relativ zu einer entsprechend angeordneten Vielzahl elektrisch leitfähiger Kontaktstellen positioniert und auf diese angeordnet werden, ohne daß ein manuelles und sequentielles Handhaben der einzelnen Leiter und Kontaktstellen erforderlich ist.

Erfindungsgemäß umfaßt der Schritt des elektrischen Verbindens des Leiters mit der Kontaktstelle das elektrische Verbinden eines zumindest teilweise elektrisch leitfähigen Hilfskontakts an den Leiter und das elektrische Verbinden des Hilfskontakts mit der Kontaktstelle. Somit erfolgt die elektrische Verbindung zwischen dem Leiter und der Kontaktstelle über ein zusätzliches (Hilfs-)Bauteil, welches in einem ersten Schritt an dem textilen Material festgelegt und mit dem Leiter elektrisch verbunden wird.

Vorzugsweise umfaßt der Schritt des elektrischen Verbindens des Hilfskontakts mit dem Leiter
- das Aufbringen eines Lotmittels auf zumindest einen Bereich des Hilfskontakts;
- das Anordnen des lotbeschichteten Bereichs des Hilfskontakts an den Leiter; und
- das Erhitzen des Hilfskontakts über den Schmelzpunkt des Lotmittels zum elektrischen Verbinden des Hilfskontakt mit dem Leiter.

Das elektrische Verbinden des Leiters mit der Kontaktstelle erfolgt somit in zwei Schritten. Zunächst wird der elektrische Leiter mit dem lotbeschichteten Hilfskontakt elektrisch verbunden, indem der Leiter relativ zu dem lotbeschichteten Bereich des Hilfskontakts positioniert und unter ausreichender Wärmeeinwirkung angepreßt wird. Besonders vorteilhaft ist es, den lotbeschichteten Hilfskontakt beispielsweise mittels einer Löteinrichtung an den in dem textilen Material angeordneten Leiter anzupressen, wobei der lotbeschichtete Bereich des Hilfskontakts dem Leiter zugewandt ist und die Löteinrichtung auf die dem lotbeschichteten Bereich gegenüberliegende Seite des Hilfskontakts einen mechanischen Druck ausübt.

Besondere Vorteile ergeben sich, wenn das textile Material ein Kunstfasergewebe mit eingebrachten elektrischen Leitern ist. In diesem Fall wird der Hilfskontakt vorzugsweise derart erhitzt, daß das Kunstfasergewebe im Auflagebereich des Hilfskontakts auf dem textilen Material schmilzt und sich somit innig mit dem Hilfskontakt verbindet. Hierdurch entsteht ein mechanisch widerstandsfähiger Verband zwischen dem Hilfskontakt und dem textilen Material, welcher insbesondere den mechanischen Belastungen, wie sie in Bekleidungsstücken auftreten können, widerstehen kann. An das derart vorbereitete textile Material mit angebrachtem Hilfskontakt kann nachfolgend mittels Löt- und/oder Klebeverfahren eine elektrische Verbindung mit der Kontaktstelle des elektronischen Bauelement hergestellt werden. Der Hilfskontakt kann direkt an die Kontaktstelle des Bauelements angeordnet werden. Alternativ kann eine derartige Anordnung gewählt werden, bei welcher die Kontaktstelle mit derjenigen Seite des textilen Materials in Berührung gelangt, welche entgegengesetzt zu der Seite ist, auf welcher der Hilfskontakt angebracht wurde.

Ferner kann der Schritt des elektrischen Verbindens des Hilfskontakts mit dem Leiter
- das Aufbringen eines Leitklebers auf zumindest einen Bereich des Hilfskontakts und
- das Anordnen des leitkleberbeschichteten Bereichs des Hilfskontakts an dem Leiter umfassen.

Vorzugsweise enthält der verwendete Leitkleber chemische Inhaltsstoffe, welche eine eventuell vorhandene Isolierummantelung der feinen Metalldrähte des Leiters zerstören, um so einen verbesserten elektrischen Kontakt zwischen dem Hilfskontakt und dem Leiter zu gewährleisten. Der Leitkleber sollte ferner derart ausgewählt werden, daß er eine sichere, den mechanischen, chemischen und thermischen Belastungen widerstehende Verbindung zwischen dem Hilfskontakt und dem textilen Material ermöglicht. Um den elektrischen Kontakt zwischen dem Hilfskontakt und dem Leiter weiter zu verbessern, kann ferner vorgesehen sein, daß in einem vorgeschalteten Verfahrensschritt zunächst eine eventuell vorhandene Isolierung des Leiters im Bereich des anzuschließenden Hilfskontakts thermisch und/oder chemisch entfernt wird.

Erfindungsgemäß ist der Hilfskontakt ein Metallplättchen, welches beispielsweise aus Silber oder Kupfer bestehen kann. Typische Flächenabmessungen eines derartigen Metallplättchens entsprechen der typischen Anzahl der parallel verlaufenden leitfähigen Garne multipliziert mit dem typischen Garndurchmesser zuzüglich einer Justierzugabe aufgrund von Justierungenauigkeiten. Bilden beispielsweise vier Garne einen elektrischen Leiter, welche jeweils einen Durchmesser von 500µm aufweisen, so beträgt die Mindestfläche A vorzugsweise A=(4x500µm)² = 4mm². Besonders bevorzugt wird ein rundes bzw. abgerundetes Metallplättchen eingesetzt Die Dicke des Metallplättchens wird vorzugsweise zwischen 50µm und 400 µm, besonders bevorzugt 100µm bis 200µm gewählt.

Vorzugsweise ist das elektronische Bauelement ein Flexband, d.h. eine flexible Leiterplatte, welche beispielsweise aus Polyethylen (PE) mit darauf aufgebrachten Leiterbahnen (beispielsweise Kupferbahnen) besteht. Ein derartiges Flexband gestattet es vorteilhafterweise, die Abstände der elektrischen Verbindungsstellen zwischen dem elektronischen Bauelement und dem textilen Material anzupassen, so daß das Flexband als "Adapterstück" fungiert. Besondere Vorteile ergeben sich, wenn als textiles Material ein Kunstfasergewebe gewählt wird, welches auf das Material des Flexbandes derart abgestimmt wird, daß durch Verschmelzen bzw. Verkleben oder ähnliche Verbindungstechniken ein nahtloser und stabiler Übergang erreicht wird.

Gemäß einer weiteren Ausführungsform umfaßt der Schritt des elektrischen Verbindens des Leiters mit der Kontaktstelle das elektrische Verbinden des Leiters mit einem weiteren in dem textilen Material angeordneten Leiter. Beispielsweise kann es erforderlich sein, sich im Gewebe kreuzende Leiter (z.B. sich kreuzende elektrische leitfähige Schuß- und Kettfäden) elektrisch zu verbinden. Das elektronische Bauelement ist in diesem Fall lediglich ein Hilfselement, welches eine sichere elektrische Verbindung zwischen den beiden in dem textilen Material angeordneten Leitern sicherstellt.

Vorzugsweise umfaßt der Schritt des elektrischen Verbindens des Leiters mit der Kontaktstelle die Schritte:
- Positionieren der Kontaktstelle des Bauelements an zumindest zwei in dem textilen Material angeordnete Leiter;
- Festlegen des Bauelements an dem textilen Material; und
- Verlöten oder leitfähiges Verkleben der Kontaktstelle mit den Leitern.
Das Bauelement kann beispielsweise durch einen Schweißprozeß oder durch einen Klebeschritt an dem textilen Material befestigt werden.

Vorzugsweise umfaßt das Verfahren die weiteren Schritte des Positionierens einer Isolierfolie an die dem Bauelement gegenüberliegende Seite des textilen Materials zu Isolierung der Kontaktstelle und des Festlegens der Isolierfolie an das textile Material. Auf diese Weise wird ein "sandwichartiger" Aufbau hergestellt, bei welchem das textile Material zwischen dem Bauelement und der Isolierfolie angeordnet ist. Die Isolierfolie erhöht die mechanische Stabilität des Aufbaus und sorgt für eine sichere elektrische Isolierung der elektrisch verbundenen Leiter. Alternativ zu der verwendeten Isolierfolie, bei welcher es sich um eine dünne Plastikfolie handeln kann, kann die Kontaktstelle durch Auftragen eines Isolierlacks oder einer Imprägnierung elektrisch isoliert werden.

Erfindungsgemäß umfaßt eine Vorrichtung
- ein textiles Material, in welchem zumindest ein flexibler, draht- und/oder fadenartiger elektrischer Leiter angeordnet ist;
- zumindest ein elektronisches Bauelement, welches eine elektrisch leitfähige Kontaktstelle aufweist,
wobei der Leiter mit der Kontaktstelle elektrisch leitfähig verbunden ist.

Bei dem textilen Material handelt es sich vorzugsweise um ein Gewebe und der Leiter umfaßt zumindest einen Schuß- und/oder Kettfaden des Gewebes. Der Leiter ist über zumindest einen teilweise leitfähigen Hilfskontakt mit der Kontaktstelle elektrisch verbunden. Der Hilfskontakt ist erfindungsgemäß ein Metallplättchen, welches insbesondere aus Kupfer oder Silber bestehen kann.

Gemäß einer weiteren bevorzugten Ausführungsform umfaßt das textile Material zumindest eine Justiereinrichtung zur Positionsjustierung des Leiters relativ zu der Kontaktstelle. Eine derartige Justiereinrichtung kann beispielsweise aus einer in das textile Material eingewebten Justierschlaufe und/oder -marke bestehen. Marken können beispielsweise durch Einweben eines Justiermusters bzw. einer Vertiefung oder durch eine unterschiedliche Einfärbung der leitfähigen und nicht-leitfähigen Fasern erzeugt werden. Vorzugsweise ist eine derartige Einfärbung der Fasern auswaschbar bzw. entfernbar ausgelegt, so daß eine derartige Justiermarke lediglich als Justierhilfe während des Aufbaus Verwendung findet und beispielsweise bei der ersten Reinigung bzw. Wäsche des textilen Materials entfernt wird. Solche Justiereinrichtungen, welche in dem textilen Material eingebracht sind, können Justier- und Handhabungsprobleme im Umgang mit dem textilen Material relativ zu dem elektronischen Bauelement deutlich vereinfachen. Ferner sind Justierungseinrichtungen auch dann von Vorteil, wenn eine elektrische Verbindung über eine relativ große Entfernung oder über eine Nahtstelle in dem textilen Material, beispielsweise einem Kleidungsstück, erfolgen soll und ein Bestückungsautomat den Verlauf der "richtigen" Gewebefaser zu verfolgen hat.

Gemäß einer weiteren bevorzugten Ausführungsform weist das textile Material zumindest eine eingewebte Bauelementtasche auf, welche zur Aufnahme des elektronischen Bauelements ausgelegt ist. Beispielsweise können mit der sogenannten Jaquard-Technik in einem bestimmten Bereich des textilen Materials die leitfähigen Kettfäden beim Webprozeß dauerhaft angehoben werden, so daß sie in diesem Bereich lose über der Gewebestruktur verlaufen. In diese so zu bildende Taschenstruktur kann ein elektronisches Bauelement eingeschoben und eventuell zusätzlich durch ein Klebeverfahren fixiert werden. Die frei verlaufenden leitfähigen Fasern stehen vorzugsweise unter einer gewissen Zugspannung und verlaufen straff über das Bauelement, welches somit sicher in der Bauelementtasche fixiert ist.

Die Erfindung wird im folgenden unter Bezugnahme auf die Zeichnungen bevorzugter Ausführungsformen beispielhaft beschrieben. Es zeigt:
- Fig. 1: schematische Ansichten in Aufsicht und Schnitt einer Ausführungsform der Erfindung, bei welcher eine Vielzahl von in einem textilen Material angeordneten Leitern mittels eines Lötschritts an einem elektronischen Bauelement angeschlossen werden;
- Fig. 2: schematische Schnittansichten in Aufsicht und Schnitt, wobei zur elektrischen Kontaktierung ein Hilfskontakt verwendet wird;
- Fig. 3: schematische Ansichten in Aufsicht und Schnitt einer weiteren Ausführungsform der Erfindung, bei welcher zwei in dem textilen Material angeordnete Leiter elektrisch miteinander verbunden werden;
- Fig. 4: schematische Ansichten in Aufsicht und Schnitt einer weiteren Ausführungsform der Erfindung, wobei ein elektronisches Bauelement in einer Bauelementtasche des textilen Materials angeordnet ist;
- Fig. 5: schematische Aufsichten einer weiteren Ausführungsform der Erfindung, wobei eine Vielzahl von in einem textilen Material angeordneten Leitern elektrisch mit einem Flexband verbunden werden; und
- Fig. 6: eine Aufsicht auf eine weitere Ausführungsform der Erfindung mit Isolierabdeckungen der erstellten Kontakte.

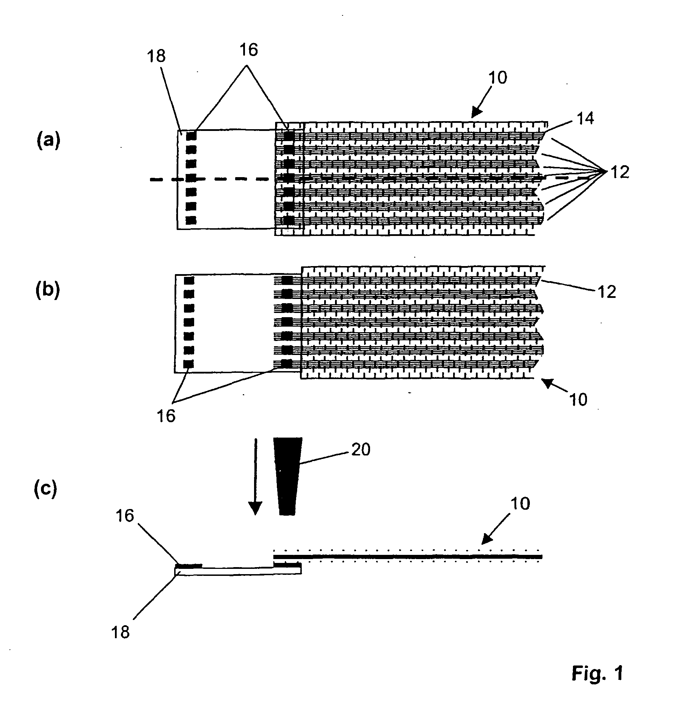

In Fig. 1 ist eine erste Ausführungsform einer erfindungsgemäßen Vorrichtung schematisch dargestellt. Mit Bezugszeichen 10 ist ein textiles Material bezeichnet, bei welchem es sich um ein Gewebe handelt. Unter Gewebe wird hierbei ein textiles Flächengebilde aus zwei sich insbesondere rechtwinklig kreuzenden Fadensystemen verstanden, welche - wie üblich - als Kette und Schuß bezeichnet werden. Die Kette liegt in Längsrichtung des Webprozesses und ist in Figuren 1(a) und (b) waagerecht dargestellt. Die Schußrichtung verläuft quer zur Webrichtung. In Figs. 1(a) und (b) sind die Schußfäden durch vertikal verlaufende, gestrichelte Linien schematisch angedeutet.

In dem textilen Material 10 sind eine Vielzahl elektrischer Leiter 12 eingewebt. Wie in Figs. 1(a) und (b) dargestellt ist, besteht jeder der Leiter 12 aus einer Vielzahl von elektrisch leitfähigen Kettfäden 14. Vorzugsweise handelt es sich bei den elektrisch leitfähigen Kettfäden 14, welche in Figs. 1(a) und (b) als waagerecht verlaufende Linien hervorgehoben dargestellt sind, aus Kunstfasern, in welche ein dünner Metalldraht eingesponnen wurde. Da jeder elektrische Leiter 12 aus einer Vielzahl elektrisch leitfähiger Kettfäden 14 aufgebaut ist, führt eine elektrische Unterbrechung eines einzelnen Kettfadens 14 nicht zu einer elektrischen Unterbrechung des Leiters 12. Bei den Kettfäden 14 kann es sich auch um dünne Metalldrähte, insbesondere Kupferdrähte, handeln, welche insbesondere mit Kunstfasern zu einem Garn versponnen sind. Vorzugsweise weist der eingesponnene dünne Metalldraht eine elektrische Isolierummantelung auf.

Um die Leiter 12, welche in dem textilen Material 10 angeordnet sind, mit entsprechend angeordneten Kontaktstellen 16 eines elektronischen Bauelements 18 elektrisch zu verbinden, werden in einem ersten Positionierungsschritt zunächst die Kontaktstellen 16 relativ zu den Leitern 12 positioniert. Dies beinhaltet insbesondere das Annähern des textilen Gewebes 10 an das elektronische Bauelement 18 derart, daß die Leiter 12 möglichst unmittelbar an den Kontaktstellen 16 anliegen. Um diesen Positionierungs- bzw. Justiervorgang des textilen Materials 10 zu dem Bauelement 18 zu erleichtern, können (nicht dargestellte) Justiereinrichtungen in dem textilen Material 10 vorgesehen sein.

Um den elektrischen Kontakt zwischen den Leitern 12 und den Kontaktstellen 16 zu verbessern, wurden in der in Fig. 1(b) gezeigten Ausführungsform die (nicht-leitenden) Schußfäden im Bereich der Kontaktstellen 16 entfernt. Somit muß bei dem elektrischen Verbindungsprozeß weniger isolierendes Material, bei welchem es sich beispielsweise um Kunstfasern handeln kann, verdrängt werden, so daß eine bessere elektrische Verbindung resultiert. Die Kontaktstellen 16 des elektronischen Bauelements 18 sind vorzugsweise mit einem Lotmittel versehen. Die elektrische Isolierung der feinen Metalldrähte in den elektrisch leitfähigen Kettfäden 14 besteht vorzugsweise aus einem Material, dessen Schmelzpunkt niedriger oder gleich demjenigen der elektrisch isolierenden Fasern und dem des Lotmittels ist.

Fig. 1(c) stellt eine Schnittansicht entlang der gestrichelten Linie von Fig. 1(a) dar. Die Leiter 12 des textilen Materials 10, welche nach dem Positioniervorgang an den zugeordneten Kontaktstellen 16 anliegen, werden mittels einer Löteinrichtung 20 auf die entsprechenden Kontaktstellen 16 mechanisch angepreßt und gleichzeitig erhitzt. Durch die Hitzezufuhr wird eine eventuell vorhandene elektrische Isolierung der feinen Metalldrähte der elektrisch leitfähigen Kettfäden 14 zerstört, so daß eine elektrische Verbindung zwischen den Kontaktstellen 16 und den Leitern 12 resultiert. Wenn das textile Material 10 aus Kunstfasern besteht und das Bauelement 18 aus einem geeigneten Material gewählt wird, entsteht ein inniger, mechanisch belastbarer Verbund aus den geschmolzenen Kunstfasern und dem Bauelement 18.

Der Andrückschritt der Leiter 12 an die Kontaktstellen 16 muß derart ausgeführt werden, daß die geschmolzene Isolierung der elektrisch leitfähigen Kettfäden 14 sowie das in Fig. 1(a) vorhandene elektrisch isolierende Schußmaterial verdrängt werden. Alternativ bzw. optional kann eine eventuell vorhandene elektrische Isolierung auch zuvor beispielsweise durch Erwärmung mit einem Laser oder durch chemische Substanzen entfernt werden. Eine weitere Möglichkeit besteht darin, die in die elektrisch leitfähigen Kettfäden 14 eingesponnenen Kupferdrähte zunächst ohne Isolationsschicht einzubringen, die gewünschten elektrischen Kontaktierungen der Leiter 12 mit den Kontaktstellen 16 durchzuführen und nachfolgend die gesamte textile Struktur 10 abschließend in einem Imprägnier- bzw. Isolier- bzw. Galvanisierschritt (z.B. mit einem Polymer) elektrisch zu isolieren. Eine derartige nachträgliche Isolation ist auch in anderen Fällen nach erfolgter Montage vorteilhaft, um die für die elektrische Kontaktierung gezielt abisolierten Stellen der Drähte wieder voneinander zu isolieren.

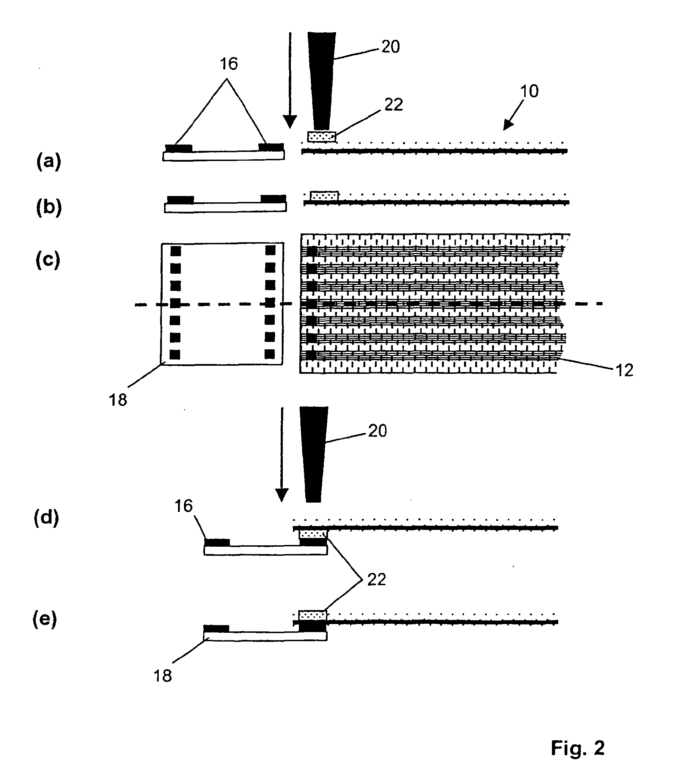

In Fig. 2 ist eine erfindungsgemäße Vorrichtung dargestellt. Bei dieser Ausführungsform kommt ein Hilfskontakt 22 zum Einsatz, welcher vor der "eigentlichen" elektrischen Kontaktierung der Leiter 12 mit den Kontaktstellen 16 des elektronischen Bauelement 18 an dem textilen Material 10 festgelegt wird. Das Verfahren zum elektrischen Verbinden der Leiter 12 mit zugeordneten Kontaktstellen 16 erfolgt somit in zwei Stufen. In Figs. 2(a) bis (c) wird in einer ersten Stufe zunächst der Hilfskontakt 22 elektrisch mit den Leitern 12 verbunden. Hierzu wird, wie in Fig. 2(a) dargestellt ist, vorzugsweise ein mit Lotmittel benetztes Metallplättchen auf die entsprechende Stelle des textilen Materials 10 aufgelegt und mit der heißen Spitze einer Löteinrichtung 20 entlang der Pfeilrichtung in Fig. 2(a) niedergedrückt.

In Fig. 2(b) ist das textile Material 10 mit daran festgelegtem Hilfskontakt 22, welcher elektrisch mit dem entsprechenden Leiter 12 verbunden ist, gezeigt. Fig. 2(c) stellt eine Aufsicht auf die Vorrichtung in diesem Prozeßstadium dar, wobei die gestrichelte Linie die Schnittachse für die in Fig. 2(b) gezeigte Schnittansicht anzeigt. Durch das Niederpressen des Hilfskontakts schmilzt das Kunstfasergewebe des textilen Materials 10, eine eventuelle elektrische Isolierung der eingewebten Metalldrähte in den elektrisch leitfähigen Kettfäden 14 sowie das Lotmittel. Nach dem Abkühlen ist der Leiter 12 mit dem Hilfskontakt leitfähig verbunden und die wiedererstarrte Kunstfaser sorgt für eine mechanisch belastbare Festlegung des Hilfskontakts an dem textilen Material. Durch dieses Verfahren wird die Gewebestruktur unterhalb des Hilfskontakts und in einem gewissen benachbarten Bereich zusammengeschmolzen und stellt eine mechanisch, thermisch und chemisch belastbare Einheit dar.

An das so vorbereitete textile Material 10 mit elektrisch angeschlossenen Hilfskontakten 22 können in einer zweiten Stufe elektrische Verbindungen mit zugeordneten Kontaktstellen 16 des elektronischen Bauelements 18 erstellt werden. Hierzu kommen zwei mögliche Anordnungsvarianten in Betracht. Zum einen kann, wie in Fig. 2(d) gezeigt ist, der Hilfskontakt 22 auf der der Kontaktstelle 16 zugewandten Seite des textilen Materials 10 angeordnet werden. Das elektrische Verbinden des Hilfskontakts 22 mit der Kontaktstelle 16 erfolgt in diesem Fall durch einen mechanischen Anpreß- und Heizschritt beispielsweise mittels einer heißen Spitze einer Löteinrichtung 20, welche auf die dem Hilfskontakt 22 gegenüberliegende Seite des textilen Materials 10 angesetzt wird. Alternativ ist es möglich, wie in Fig. 2(e) dargestellt, das textile Material 10 mit festgelegtem Hilfskontakt 22 derart an die Kontaktstelle 16 anzuordnen, daß zwischen dem Hilfskontakt 22 und der Kontaktstelle 16 (geschmolzene und seitlich verdrängte) Schußfäden des textilen Materials 10 angeordnet sind.

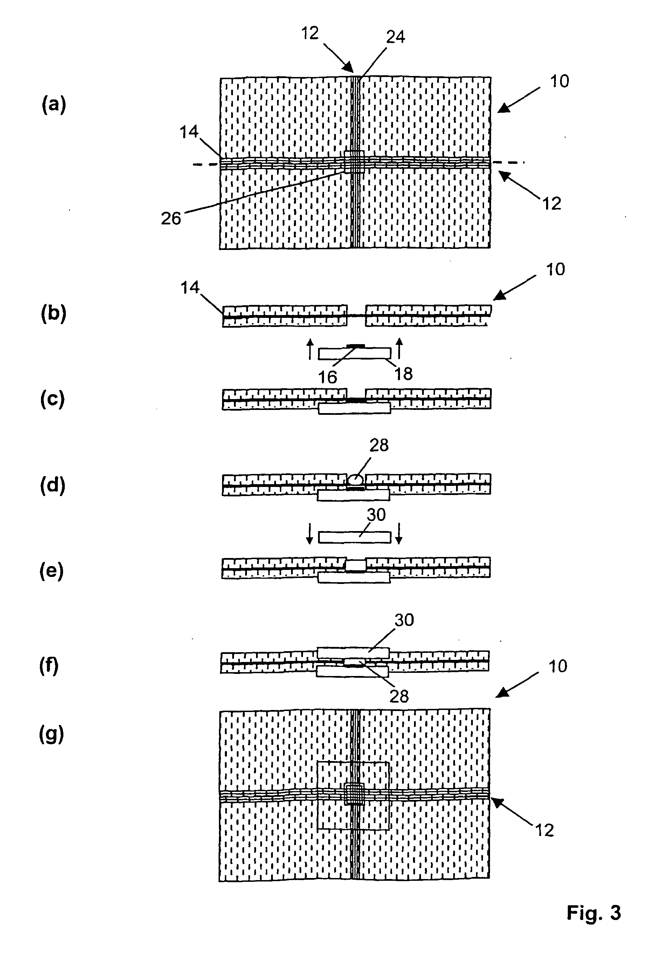

In Fig. 3 ist eine weitere Ausführungsform der Vorrichtung dargestellt. Bei dieser Ausführungsform wird eine elektrische Verbindung zwischen einem in Kettrichtung verlaufendem Leiter 12 mit einem in Schußrichtung verlaufendem Leiter 12 hergestellt. Der sich in Kettrichtung erstreckende Leiter 12 ist aus einer Vielzahl von elektrisch leitfähigen Kettfäden 14 und der sich in Schußrichtung erstreckenden Leiter 12 aus einer Vielzahl von elektrisch leitfähigen Schußfäden 24 aufgebaut. Bei diesem elektrischen Verbindungsverfahren wird zunächst in dem Kreuzungsgebiet der Kett- und Schußfäden 14 und 24 durch einen thermischen oder chemischen Schritt die nicht-leitenden Fasern sowie eine eventuell vorhandene Isolierummantelung der eingesponnenen Metalldrähte entfernt. Das Kreuzungsgebiet ist in Fig. 3(a) durch ein mit dem Bezugszeichen 26 bezeichnetes Rechteck dargestellt.

Nachfolgend wird, wie in Fig. 3(b) im Schnitt entlang der gestrichelten Linie von Fig. 3(a) dargestellt ist, ein Bauelement 18 mit einer daran angebrachten Kontaktstelle 16 die Unterseite des textilen Materials 10 derart angenähert, daß die elektrisch leitfähige Kontaktstelle 16 in Berührung mit den sich kreuzenden, elektrisch leitfähigen Schuß- und Kettfäden 14 und 24 gelangt. Das Ergebnis ist in Fig. 3(c) dargestellt. Bei dem Bauelement 18 handelt es sich in diesem Fall lediglich um eine Hilfsvorrichtung, welche den sicheren Kontakt zwischen den sich kreuzenden, elektrisch leitfähigen Fadensystemen des Gewebes sicherstellen soll. Beispielsweise ist das Bauelement 18 eine ca. 100µm dicke Kunststoffolie, auf welcher mittig ein Metallpad (insbesondere ein geätztes typischerweise ca. 20µm dickes Kupferpad, welches ggf. zusätzlich mit einem Lotmittel beschichtet ist), aufgebracht ist. Die Abmessung dieser Kunststoffolie ist vorzugsweise derart bemessen, daß ihre Anlagefläche an dem textilen Material 10 ein sicheres Verkleben und/oder Verschweißen mit diesem gestattet.

Wie in Fig. 3(d) dargestellt ist, werden die sich im Kontaktbereich 26 kreuzenden, elektrisch leitfähigen Schuß- und Kettfäden 14 und 24 nachfolgend mit einem Leitkleber oder einem Lotmittel 28 elektrisch mit der Kontaktstelle 16 verbunden. Alternativ kann die Verbindung mit der Kontaktstelle 16 durch Auflöten eines Hilfskontakts, insbesondere eines kleinen Metallplättchens gemäß Fig. 2 ausgeführt werden. Der Kontaktbereich bzw. Kreuzungspunkt 26 der elektrisch leitfähigen Fadensysteme wird nachfolgend vorzugsweise durch eine weitere, von oben aufgelegte und verschweißte Isolierfolie 30 oder durch Auftragen eines Isolierlacks elektrisch isoliert. Die Vorrichtung in diesem Herstellungsstadium ist schematisch in Fig. 3(f) im Schnitt und in Fig. 3(g) in Aufsicht dargestellt.

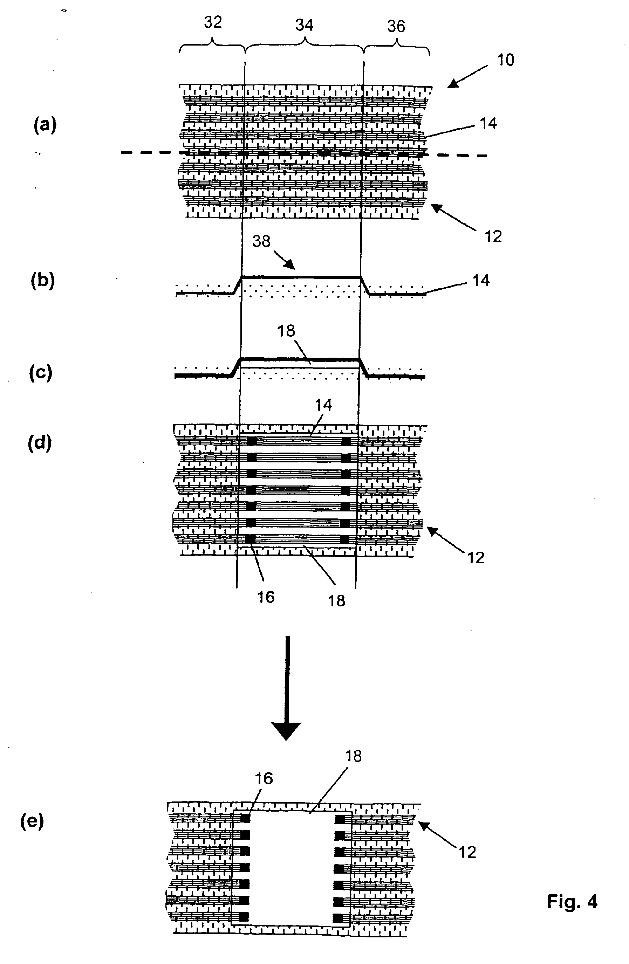

In Fig. 4 ist eine weitere Ausführungsform der Vorrichtung dargestellt. Bei dieser Ausführungsform kann das elektronische Bauelement 18 in einer Bauelementtasche 38 selbstjustierend in dem textilen Material 10 gehalten werden. Hierzu werden, wie in Fig. 4(a) dargestellt ist, in einem Bereich 34 des textilen Materials 10 die elektrisch leitfähigen Kettfäden 14 beim Webprozeß dauerhaft angehoben, so daß sie in diesem Bereich lose überhalb der übrigen Gewebestruktur verlaufen. In den angrenzenden Bereichen 32 und 36 sind die elektrisch leitfähigen Kettfäden 14, welche die Leiter 12 bilden, "normal" in das textile Material 10 eingewebt. Das Anheben der Kettfäden 14 in dem Bereich 34 kann beispielsweise mittels der Jaquard-Technik erfolgen. Hierdurch wird, wie in Fig. 4(b) dargestellt ist, eine Bauelementtasche 38 gebildet, in welche das Bauelement 18 eingeschoben werden kann (Fig. 4(c)). Das Bauelement 18 wird in der Bauelementtasche 38 selbstjustierend gehalten, da die frei verlaufenden leitfähigen Kettfäden 14 vorzugsweise unter einer gewissen Zugspannung verlaufen und straff über dem Modul anliegen.

Wenn das Bauelement 18, wie in Fig. 4(d) dargestellt ist, zwei gegenüberliegende Reihen von Kontaktstellen 16 aufweist, können die Kettfäden 14 anschließend (d.h. nach Kontaktierung mittels eines der in Zusammenhang mit Figs. 1 bis 3 beschriebenen Verfahren) mit einem geeigneten Schneidwerkzeug zwischen den beiden Reihen der Kontaktstellen 16 entfernt werden, so daß die eventuell unerwünschten Kurzschlüsse aufgehoben werden. Das Ergebnis eines derartigen Schneidvorgangs zur Entfernung der elektrischen Leiter zwischen den Reihen der Kontaktstellen 16 ist in Fig. 4(e) dargestellt. Ein solches Verfahren könnte insbesondere dann vorteilhaft sein, wenn entlang des textilen Materials mehrere, mit einem seriellen Interface zu eine Kette verschaltete Chips (beispielsweise Sensorchips) eingebracht werden sollen.

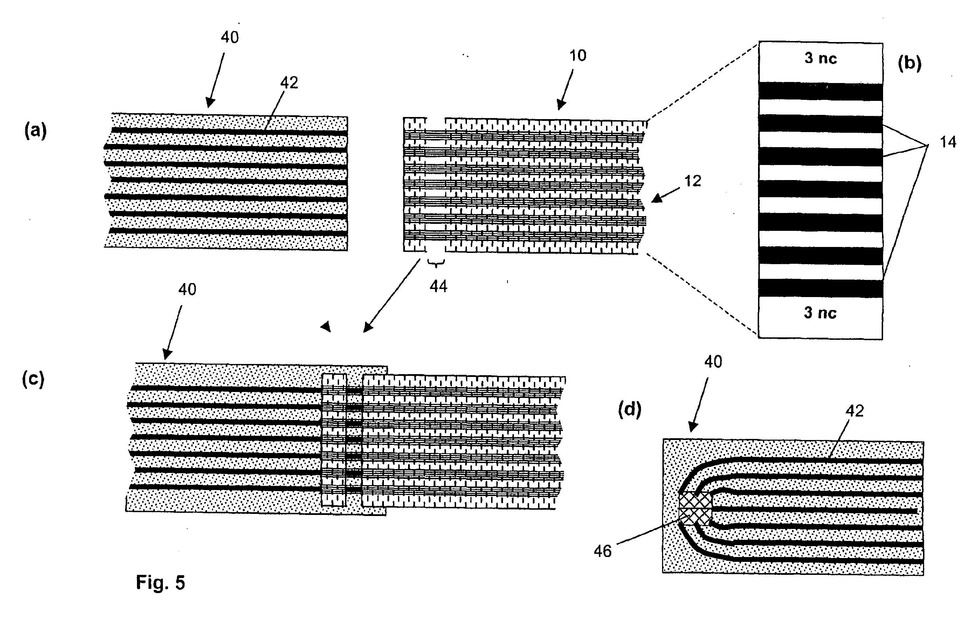

In Fig. 5 ist eine weitere Ausführungsform der Vorrichtung dargestellt. Bei dieser Ausführungsform wird als elektronisches Bauelement nicht ein Chip unmmittelbar an die Leiter 12 angeschlossen, sondern über ein sogenanntes Flexband 40, welches als Adapterstück fungiert. Bei dem Flexband 40 handelt es sich beispielsweise um eine flexible Leiterplatte aus einem Polyesterfilm, auf welchem durch geeignete Abscheide- und Ätzverfahren metallische Leiterbahnen 42, insbesondere Kupferbahnen, aufgebracht worden sind (vgl. Fig. 5(a)). Vorzugsweise besteht die Grundlage des Flexbandes 40 sowie die Kunstfasern des textilen Materials 10 aus einer möglichst ähnlichen Materialgruppe, so daß bei einem Verschmelzen bzw. Verkleben bzw. einem Ultraschall-Schweißvorgang eine feste mechanische Verbindung erreicht werden kann.

Die elektrische Kontaktierung der Leiter 12 an die Metallbahnen 42 des Flexbandes 40 kann analog zu den anhand von Figs. 1 und 2 beschriebenen elektrischen Verbindungsverfahren durchgeführt werden. Dem elektronischen Bauelement 18 entspricht in diesem Fall das Flexband 40 und den Kontaktstellen 16 entsprechen die Leiterbahnen 42. Optional können in dem Bereich 44, in welchem die Leiter 12 über den Leiterbahnen 42 verlaufen, die (nicht-leitenden) Schußfäden entfernt werden, um die elektrisch leitfähigen Kettfäden 14 besser zugänglich zu machen und einen besseren elektrischen Kontakt zu erzielen.

Nach dem Herstellen der elektrischen Verbindung zwischen den Leitern 12 und den Leiterbahnen 42 erfolgt vorzugsweise eine elektrische Isolierung des Kontaktbereichs zum Schutz vor elektrischen Kurzschlüssen und Korrosion der Materialien. Das kontaktierte textile Material 10 mit dem angebrachten Flexband 40 ist in Fig. 5(c) dargestellt. In Fig. 5(d) ist eine mögliche Anschlußvariante mittels des Flexbandes 40 gezeigt. Hierbei ist ein integrierter Schaltkreis 46 an die Leiterbahnen 42 des Flexbandes 40 angeschlossen. Dies ist insbesondere dann von Vorteil, wenn die auf dem integrierten Schaltkreis 46 angebrachten Kontaktflächen zu klein für das im allgemeinen grobere textile Raster sind. Das Flexband 40 bietet somit als Adapterstück die Möglichkeit, die Abstände der elektrischen Verbindungspunkte zwischen Elektronik und Textil anzupassen. Verfahren zur elektrischen Kontaktierung und Befestigung des Flexbandes 40 mit externen elektronischen Bauelementen 46 sind hinlänglich bekannt. Zu beachten ist, daß die Größe und der Abstand von Anschlußpads integrierter Schaltkreise typischerweise in der Größenordnung von 0,1 mm liegt und damit im allgemeinen kleiner als typische Perioden eines textilen Gewebes (Größenordnung 1 mm) sind. Dies gilt insbesondere dann, wenn aus Gründen der Redundanz pro eigentlichem Leiter 12 mehrere im Gewebe nebeneinanderliegende Schuß- bzw. Kettfäden zusammengeschaltet werden sollen. Eine typische Fadendichte in feinen Geweben beträgt etwa 20 Fäden pro Zentimeter, was in etwa einer Periode (pitch) von 0,5 mm entspricht.

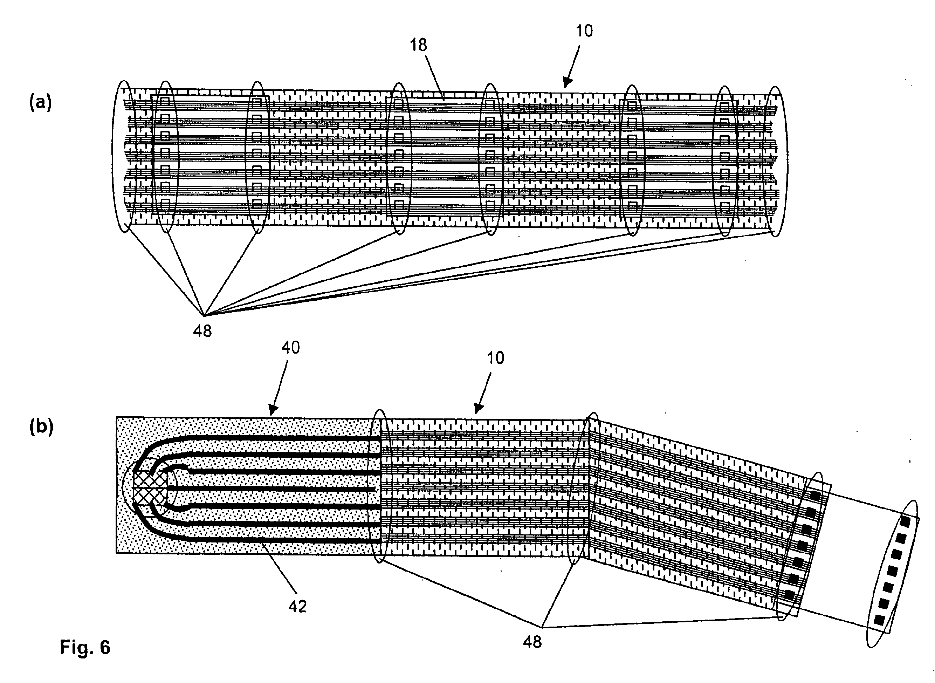

In Fig. 6 ist eine weitere bevorzugte Ausführungsform der Vorrichtung gezeigt. Bedingt durch die Montage der elektronischen Bauelemente 18 gemäß einer der oben beschriebenen Ausführungsformen entstehen offene, nicht isolierte Stellen, welche vorteilhafterweise wieder elektrisch isoliert werden sollten, um z.B. gegenüber Feuchtigkeitseinflüssen gekapselt zu sein. Vorteilhafterweise erfolgt dies durch Eingießen der betreffenden Stellen, insbesondere der Kontaktbereiche der Kontaktstelle 16 und der Leiter 12, mit einem zur elektrischen Isolierung geeigneten Kapselmaterial. In Fig. 6(a) sind einige Kontaktbereiche gezeigt, welche vorzugsweise einer elektrisch isolierenden Kapselung unterworfen werden. Das Isoliermaterial 48 kann beispielsweise ein weiches Silikon oder eine flexible thermoplastische Folie aus vorzugsweise einer ähnlichen Materialgruppe wie die Textilfaser sein, welche auf das textile Material 10 gelegt und mit diesem verschmolzen werden kann. Eine derartige Kapselung ist vorteilhafterweise auch an Schnittkanten senkrecht zum Verlauf der elektrisch leitfähigen Fasern 14 anzubringen, insbesondere an den Enden von Stoffbahnen oder an Nähten. Alternativ ist auch eine nachträgliche Galvanisierung insbesondere mit isolierenden Polymeren der gesammten Leiterbahnstruktur möglich, so daß alle offenen Stellen, die durch Lötpunkte oder Defekte zustande kommen, elektrisch isoliert werden.

### Bezugszeichenliste

- 10: textile Material
- 12: in dem textilen Material angeordneter elektrischer Leiter
- 14: elektrisch leitfähiger Kettfaden des textilen Materials
- 16: Kontaktstelle des elektronischen Bauelements
- 18: elektronisches Bauelement (z.B. Chip)
- 20: Löteinrichtung
- 22: Hilfskontakt, insbesondere Metallplätchen
- 24: elektrisch leitfähige Schußfäden
- 26: Kreuzungsgebiet elektrisch leitfähiger Schuß- und Kettfäden
- 28: Lotmittel oder Leitkleber
- 30: Isolierfolie
- 32: normaler Bereich des Gewebes
- 34: Bereich mit durch Jaquard-Technik angehobenen elektrisch leitfähigen Kettfäden
- 36: normaler Bereich des Gewebes
- 38: Bauelementtasche
- 40: Flexband
- 42: Leiterbahn
- 44: Bereich, in welchem isolierende Schußfäden entfernt wurden
- 46: integrierter Schaltkreis (IC)
- 48: Isoliermaterial

## Patentansprüche

1. Verfahren zum elektrischen Verbinden eines elektrischen Leiters (12) mit einem elektronischen Bauelement (18) mit den Schritten:
- Bereitstellen eines texilen Materials (10), in welchem zumindest ein flexibler, draht- und/oder fadenartiger elektrischer Leiter (12) angeordnet ist;
- Positionieren des elektrischen Leiters (12) relativ zu einer elektrisch leitfähigen Kontaktstelle (16) des elektronischen Bauelements (18); und
- elektrisches Verbinden des Leiters (12) mit der Kontaktstelle (16),
wobei der Schritt des elektrischen Verbindens des Leiters (12) mit der Kontaktstelle (16) das elektrische Verbinden eines zumindest teilweise elektrisch leitfähigen Hilfskontakts (22) an den Leiter (12) und das elektrische Verbinden des Hilfskontakts (22) mit der Kontaktstelle (16) umfaßt,
**dadurch gekennzeichnet daß**,
wobei der Hilfskontakt (22) ein Metallplätchen ist.

2. Verfahren nach Anspruch 1, wobei der Leiter (12) eine elektrische Isolierung aufweist und der Schritt des Verbindens des Leiters (12) mit der Kontaktstelle (16) das zumindest teilweise chemische und/oder thermische Entfernen der Isolierung umfaßt.

3. Verfahren nach einem der vorangegangenen Ansprüche, wobei der Schritt des elektrischen Verbinden des Leiters (12) mit der Kontaktstelle (16) das Aufbringen eines Lotmittels (28) auf zumindest einen Bereich der Kontaktstelle (16) und das mechanische Andrücken des Leiters (12) auf die mit Lotmittel (28) versehene Kontaktstelle (16) umfaßt.

4. Verfahren nach Anspruch 3, wobei das Andrücken des Leiters (12) mittels einer Löteinrichtung (20) erfolgt.

5. Verfahren nach einem der vorangegangenen Ansprüchen, wobei das Bauelement (18) eine Vielzahl von elektrisch leitfähigen Kontaktstellen (16) und das textile Material (10) eine Vielzahl von elektrischen Leitern (12) und der Schritt des Positionierens das gleichzeitige Anordnen der Leiter (12) an die Kontaktstellen (16) umfaßt.

6. Verfahren nach einem der vorangegangenen Ansprüche, wobei der Schritt des elektrischen Verbindens des Hilfskontakts (22) mit dem Leiter (12)
- das Aufbringen eines Lotmittels (28) auf zumindest einen Bereich des Hilfskontakts (22),
- das Anordnen des lotbeschichteten Bereichs des Hilfskontakts (22) an den Leiter (12) und
- das Erhitzen des Hilfskontakts (22) über den Schmelzpunkt des Lotmittels (28) zum elektrischen Verbinden des Hilfskontakts (22) mit dem Leiter (12) umfaßt.

7. Verfahren nach einem der Anspruche 1-5, wobei der Schritt des elektrischen Verbindens des Hilfskontakts (22) mit dem Leiter (12)
- das Aufbringen eines Leitklebers auf zumindest einen Bereich des Hilfskontakts (22) und
- das Anordnen des leitkleberbeschichteten Bereichs des Hilfskontakts (22) an den Leiter (12) umfaßt.

8. Verfahren nach einem der vorangegangenen Ansprüche, wobei das elektronische Bauelement (18) ein Flexband (40) ist.

9. Verfahren nach einem der vorangegangenen Ansprüche, wobei der Schritt des elektrischen Verbindens des Leiters (12) mit der Kontaktstelle (16) das elektrische Verbinden des Leiters (12) mit einem weiteren in dem textilen Material (10) angeordneten Leiter (12) umfaßt.

10. Verfahren nach Anspruch 9, wobei der Schritt des elektrischen Verbindens des Leiters (12) mit der Kontaktstelle (16) folgende Schritte umfaßt:
- Positionieren der Kontaktstelle (16) des Bauelements (18) an zumindest zwei in dem textilen Material (10) angeordnete Leiter (12);
- Festlegen des Bauelements (18) an dem textilen Material (10); und
- Verlöten oder leitfähiges Verkleben der Kontaktstelle (16) mit den Leitern (12).

11. Verfahren nach Anspruch 9 oder 10 mit den weiteren Schritten des Positionierens einer Isolierfolie (30) an die dem Bauelement (18) gegenüberliegenden Seite des textilen Materials (10) zur Isolierung der Kontaktstelle (16) und des Festlegens der Isolierfolie (30) an das textile Material (10).

12. Vorrichtung mit
- einem textilen Material (10), in welchem zumindest ein flexibler, draht- und/oder fadenartiger elektrischer Leiter (12) angeordnet ist;
- zumindest ein elektronisches Bauelement (18), welches eine elektrisch leitfähige Kontaktstelle (16) aufweist,
wobei der Leiter (12) mit der Kontaktstelle (16) elektrisch leitfähig verbunden ist,
wobei der Leiter (12) über einen zumindest teilweise leitfähigen Hilfskontakt (22) mit der Kontaktstelle (16) elektrisch verbunden ist, **dadurch gekennzeichnet, daß** wobei der Hilfskontakt (22) ein Metallplätchen ist.

13. Vorrichtung nach Anspruch 12, wobei das textile Material (10) zumindest eine Justiereinrichtung zur Positionsjustierung des Leiters (12) relativ zu der Kontaktstelle (16) umfaßt.

14. Vorrichtung nach Anspruch 12 oder 13, wobei das textile Material (10) zumindest eine eingewebte Bauelementtasche (38) aufweist, welche zur Aufnahme des elektronischen Bauelements (18) ausgelegt ist.

## Claims

1. Method for electrically connecting an electrical conductor (12) to an electronic component (18) having the following steps:
- provision of a textile material (10) in which at least one flexible, wire- and/or thread-like electrical conductor (12) is arranged;
- positioning of the electrical conductor (12) relative to an electrically conductive contact point (16) of the electronic component (18); and
- electrical connection of the conductor (12) to the contact point (16), the step of electrical connection of the conductor (12) to the contact point (16) comprising the electrical connection of an at least partly electrically conductive auxiliary contact (22) to the conductor (12) and the electrical connection of the auxiliary contact (22) to the contact point (16),
**characterized in that** the auxiliary contact (22) is a metal lamina.

2. Method according to Claim 1, the conductor (12) having an electrical insulation and the step of connection of the conductor (12) to the contact point (16) comprising the at least partial chemical and/or thermal removal of the insulation.

3. Method according to one of the preceding claims, the step of electrical connection of the conductor (12) to the contact point (16) comprising the application of a solder agent (28) to at least one region of the contact point (16) and the mechanical pressing of the conductor (12) onto the contact point (16) provided with solder agent (28).

4. Method according to Claim 3, the conductor (12) being pressed on by means of a soldering device (20).

5. Method according to one of the preceding claims, the component (18) comprising a multiplicity of electrically conductive contact points (16) and the textile material (10) comprising a multiplicity of electrical conductors (12) and the positioning step comprising the simultaneous arrangement of the conductors (12) at the contact points (16).

6. Method according to one of the preceding claims, the step of electrical connection of the auxiliary contact (22) to the conductor (12) comprising
- the application of a solder agent (28) to at least one region of the auxiliary contact (22),
- the arrangement of the solder-coated region of the auxiliary contact (22) onto the conductor (12) and
- the heating of the auxiliary contact (22) above the melting point of the solder agent (28) in order to electrically connect the auxiliary contact (22) to the conductor (12).

7. Method according to one of Claims 1-5, the step of electrical connection of the auxiliary contact (22) to the conductor (12) comprising
- the application of a conductive adhesive to at least one region of the auxiliary contact (22) and
- the arrangement of the conductive-adhesive-coated region of the auxiliary contact (22) onto the conductor (12).

8. Method according to one of the preceding claims, the electric component (18) being a flexible strip (40).

9. Method according to one of the preceding claims, the step of electrical connection of the conductor (12) to the contact point (16) comprising the electrical connection of the conductor (12) to a further conductor (12) arranged in the textile material (10).

10. Method according to Claim 9, the step of electrical connection of the conductor (12) to the contact point (16) comprising the following steps:
- positioning of the contact point (16) of the component (18) onto at least two conductors (12) arranged in the textile material (10);
- fixing of the component (18) at the textile material (10); and
- soldering or conductive adhesive bonding of the contact point (16) to the conductors (12).

11. Method according to Claim 9 or 10 having the further steps of positioning of an insulating film (30) onto that side of the textile material (10) which is opposite to the component (18) for the insulation of the contact point (16), and fixing of the insulating film (30) onto the textile material (10).

12. Device having
- a textile material (10) in which at least one flexible, wire- and/or thread-like electrical conductor (12) is arranged;
- at least one electronic component (18) having an electrically conductive contact point (16),
- the conductor (12) being electrically conductively connected to the contact point (16), the conductor (12) being electrically connected to the contact point (16) via an at least partly conductive auxiliary contact (22),
**characterized in that** the auxiliary contact (22) is a metal lamina.

13. Device according to Claim 12, the textile material (10) comprising at least one adjusting device for positional adjustment of the conductor (12) relative to the contact point (16).

14. Device according to Claim 12 or 13, the textile material (10) having at least one woven-in component pocket (38) designed for receiving the electronic component (18).

## Revendications

1. Procédé pour la connexion électrique d'un conducteur électrique (12) à un composant électronique (18), avec les étapes suivantes:
- préparation d'une matière textile (10), dans laquelle est disposé au moins un conducteur électrique flexible (12) sous forme de fil et/ou de filament;
- positionnement du conducteur électrique (12) par rapport à un point de contact électriquement conducteur (16) du composant électronique (18); et
- connexion électrique du conducteur (12) avec le point de contact (16),
- dans lequel l'étape de connexion électrique du conducteur (12) avec le point de contact (16) comprend la connexion électrique d'un contact auxiliaire (22) au moins en partie électriquement conducteur avec le conducteur (12) et la connexion électrique du contact auxiliaire (22) avec le point de contact (16),
**caractérisé en ce que** le contact auxiliaire (22) est une plaquette métallique.

2. Procédé selon la revendication 1, dans lequel le conducteur (12) comprend un isolant électrique et l'étape de connexion du conducteur (12) avec le point de contact (16) comprend l'enlèvement chimique et/ou thermique au moins partiel de l'isolant.

3. Procédé selon l'une quelconque des revendications précédentes, dans lequel l'étape de connexion électrique du conducteur (12) avec le point de contact (16) comprend le dépôt d'un métal de brasage (28) sur au moins une zone du point de contact (16) et l'application mécanique du conducteur (12) sur le point de contact (16) pourvu du métal de brasage (28).

4. Procédé selon la revendication 3, dans lequel l'application du conducteur (12) est effectuée au moyen d'un dispositif de brasage (20).

5. Procédé selon l'une quelconque des revendications précédentes, dans lequel le composant (18) comporte une pluralité de points de contact électriquement conducteurs (16) et la matière textile (10) comprend une pluralité de conducteurs électriques (12) et l'étape de positionnement comprend la disposition simultanée des conducteurs (12) sur les points de contact (16).

6. Procédé selon l'une quelconque des revendications précédentes, dans lequel l'étape de connexion électrique du contact auxiliaire (22) avec le conducteur (12) comprend:
- le dépôt d'un métal de brasage (28) sur au moins une zone du contact auxiliaire (22),
- la disposition de la zone du contact auxiliaire (22) revêtue de métal de brasage sur le conducteur (12), et
- le chauffage du contact auxiliaire (22) au-delà du point de fusion du métal de brasage (28) pour la connexion électrique du contact auxiliaire (22) avec le conducteur (12).

7. Procédé selon l'une quelconque des revendications 1 - 5, dans lequel l'étape de connexion électrique du contact auxiliaire (22) avec le conducteur (12) comprend:
- le dépôt d'un adhésif conducteur sur au moins une zone du contact auxiliaire (22), et
- la disposition de la zone du contact auxiliaire (22) revêtue d'adhésif conducteur sur le conducteur (12).

8. Procédé selon l'une quelconque des revendications précédentes, dans lequel le composant électronique (18) est une bande Flexband (40).

9. Procédé selon l'une quelconque des revendications précédentes, dans lequel l'étape de connexion électrique du conducteur (12) avec le point de contact (16) comprend la connexion électrique du conducteur (12) avec un autre conducteur (12) disposé dans la matière textile (10).

10. Procédé selon la revendication 9, dans lequel l'étape de connexion électrique du conducteur (12) avec le point de contact (16) comprend les étapes suivantes:
- positionnement du point de contact (16) du composant (18) sur au moins deux conducteurs (12) disposés dans la matière textile (10);
- fixation du composant (18) sur la matière textile (10); et
- brasage ou collage conducteur du point de contact (16) avec les conducteurs (12).

11. Procédé selon la revendication 9 ou 10, comportant les étapes supplémentaires de positionnement d'un film isolant (30) sur le côté de la matière textile (10) faisant face au composant (18) pour l'isolation du point de contact (16) et de fixation du film isolant (30) sur la matière textile (10).

12. Dispositif avec
- une matière textile (10) dans laquelle est disposé au moins un conducteur électrique flexible (12) sous forme de fil et/ou de filament;
- au moins un composant électronique (18), qui présente un point de contact électriquement conducteur (16),
- dans lequel le conducteur (12) est relié de façon électriquement conductrice avec le point de contact (16),
- dans lequel le conducteur (12) est relié électriquement au point de contact (16) par un contact auxiliaire au moins partiellement conducteur (22),
**caractérisé en ce que**
le contact auxiliaire (22) est une plaquette métallique.

13. Dispositif selon la revendication 12, dans lequel la matière textile (10) comprend au moins un dispositif d'ajustement pour l'ajustement de la position du conducteur (12) par rapport au point de contact (16).

14. Dispositif selon la revendication 12 ou 13, dans lequel la matière textile (10) comprend au moins une poche de composant (38) intégrée dans le tissu, qui est conçue pour recevoir le composant électronique (18).
